# EUROPÄISCHE PATENTSCHRIFT

(11) **EP 2 468 915 B1**
(45) Veröffentlichungstag und Bekanntmachung des Hinweises auf die Patenterteilung: **19.06.2013**
(21) Anmeldenummer: 11009085.9
(22) Anmeldetag: 16.11.2011
(51) Int. Cl.: C23C 14/00, C23C 14/35, C23C 14/54

(54) **Verfahren zum Abscheiden dielektrischer Schichten im Vakuum sowie Verwendung des Verfahrens**
Method for separating dielectric layers in a vacuum and use of the method
Procédé de séparation de couches diélectriques sous vide et utilisation du procédé

(30) Priorität: 22.12.2010 DE 102010055659
(43) Veröffentlichungstag der Anmeldung: 27.06.2012
(73) Patentinhaber: Fraunhofer-Gesellschaft zur Förderung der angewandten Forschung e.V., 80686 München (DE); Technische Universität Dresden, 01062 Dresden (DE)
(72) Erfinder: Bartzsch, Hagen, 01309 Dresden (DE); Frach, Peter, 01454 Radeberg (DE); Fahland, Matthias, 01257 Dresden (DE); Gottfried, Christian, 01219 Dresden (DE); Pötschick, Pierre, 01326 Dresden (DE)

(56) Entgegenhaltungen:
- WO-A2-2005/073427
- DE-A1- 19 824 364
- DE-A1-102006 060 057
- DE-A1-102008 028 542
- EE Y C ET AL: "Formation and characterization of Ti-Si-N-O barrier films", THIN SOLID FILMS, ELSEVIER-SEQUOIA S.A. LAUSANNE, CH, Bd. 504, Nr. 1-2, 10. Mai 2006 (2006-05-10), Seiten 218-222, XP025006105, ISSN: 0040-6090, DOI: 10.1016/J.TSF.2005.09.127 [gefunden am 2006-05-10]

## Beschreibung

Die Erfindung betrifft ein Verfahren zum Abscheiden von dielektrischen Schichten im Vakuum, welche beispielsweise bei Sensoren oder in der Photovoltaik eingesetzt werden, um elektrisch leitfähige Materialien voneinander elektrisch zu isolieren. Des Weiteren betrifft die Erfindung auch eine Verwendung des Verfahrens.

### Stand der Technik

Es sind verschiedene Verfahren aus der Vakuumtechnik zum Abscheiden dielektrischer Schichten bekannt. Aus dem Bereich der physikalischen Dampfabscheidung (PVD) werden beispielsweise bei einer Gruppe von Verfahren dielektrische Schichten mittels reaktiven oder auch nichtreaktiven Magnetron-Sputterns abgeschieden (DD 146 306 A1, DE 10 2009 016 708 A1). Die auf diese Weise abgeschiedenen Schichten weisen sehr gute elektrische Isolationseigenschaften und üblicherweise auch eine gute Haftung an einem Substrat auf. Nachteilig wirkt sich hingegen aus, dass derartige Schichten sehr spröde sind und nur eine sehr geringe Dehnbarkeit aufweisen. Auf flexiblen Substraten oder bei Anwendungen mit thermischen Wechselbedingungen und auf Substraten mit vom Schichtmaterial abweichenden thermischen Ausdehnungskoeffizienten neigen diese Schichten daher oftmals zur Rissbildung, wodurch die Schichtfunktion beeinträchtigt wird.

Zum Abscheiden dielektrischer Schichten sind auch Verfahren aus dem Bereich der chemischen Dampfabscheidung (CVD) offenbart. DE 40 08 405 C1 gibt ein Verfahren zum Abscheiden einer dielektrischen Schicht innerhalb eines Schichtstapels auf einem Reflektor an. Zum Abscheiden der dielektrischen Schicht bedient man sich hierbei eines plasmaunterstützten CVD-Verfahrens. Mittels derartiger Verfahren können Schichten auf großflächigen Substraten mit hoher Beschichtungsrate abgeschieden werden. Allerdings weisen derartige abgeschiedene Schichten oftmals keine so hohe elektrische Isolationsfestigkeit auf wie gesputterte Schichten.

In DE 10 2007 033 665 A1 wird vorgeschlagen, zunächst eine Metallschicht abzuscheiden, welche im Anschluss einem Sauerstoffplasma ausgesetzt, dadurch nachoxidiert und infolgedessen dessen dielektrisch wird. Ein Nachteil derartiger Verfahren besteht darin, dass nur dünne Schichten bzw. nur die Oberfläche einer dickeren Schicht nachoxidiert werden kann. Für das Abscheiden dickerer dielektrischer Schichten ist dieses Verfahren ungeeignet.

Neben dem Abscheiden einer dielektrischen Einzelschicht ist es ebenfalls bekannt, die Funktion einer elektrischen Isolation mittels eines Mehrschichtsystems umzusetzen.

DE 101 28 491 A1 offenbart Verfahren, bei denen mindestens zwei dielektrische Materialien mit unterschiedlicher Brechzahl als separate Einzelschichten ausgebildet werden. Zum Abscheiden der mindestens zwei dielektrischen Einzelschichten wird vorgeschlagen, PVD- oder CVD-Abscheideverfahren zu verwenden, welchen wiederum die oben genannten Vor- und Nachteile anhaften.

Ferner ist aus WO 2005/073427 A2 ein Verfahren zum Abscheiden eines Schichtstapels bekannt, der als Wechselschichtsystem aus gesputterten Glättungsschichten und transparenten keramischen Schichten ausgebildet wird. Dabei wird während des Abscheidens der Glättungsschichten ein Magnetronplasma in einer evakuierten Beschichtungskammer betrieben und gleichzeitig ein Monomer in die Beschichtungskammer eingelassen. Mit diesem Verfahren lassen sich Schichtsysteme mit sehr guten Barriereeigenschaften gegenüber Sauerstoff und Wasserdampf herstellen.

### Aufgabenstellung

Der Erfindung liegt daher das technische Problem zugrunde ein Verfahren und eine Verwendung dafür zu schaffen, mit welchen die Nachteile aus dem Stand der Technik überwunden werden. Insbesondere sollen mit dem Verfahren dielektrische Schichten mit hoher Abscheiderate und mit guten Eigenschaften hinsichtlich der elektrischen Isolation abgeschieden werden. Die mit dem Verfahren hergestellten Schichten sollen über eine gute Haftfestigkeit auf Substraten verfügen und eine höhere Elastizität als gesputterte Schichten aufweisen.

Die Lösung des technischen Problems ergibt sich durch die Gegenstände mit den Merkmalen der Ansprüche 1 und 9. Weitere vorteilhafte Ausgestaltungen der Erfindung ergeben sich aus den abhängigen Ansprüchen.

Ein erfindungsgemäßes Verfahren zum Abscheiden einer dielektrischen Schicht auf einem Substrat stellt eine Kombination aus einem reaktiven Sputterverfahren und einem Verfahren der plasmaunterstützten chemischen Dampfabscheidung (Plasma Enhanced Chemical Vapor Deposition - PECVD), bei welchem das Plasma mittels eines Magnetrons erzeugt wird (auch magPECVD genannt), dar. Während bei einem magPECVD-Prozess das Magnetron vorwiegend zum Erzeugen eines Plasmas verwendet wird und ein Sputterabtrag vom Magnetrontarget nicht erforderlich bzw. sogar nicht erwünscht ist, so ist bei einem erfindungsgemäßen Verfahren ein Sputterabtrag vom Target und eine reaktive Umsetzung der abgestäubten Targetpartikel mit einem Reaktivgas zwingend erforderlich.

Beim erfindungsgemäßen Verfahren zum Abscheiden einer dielektrischen Schicht auf einem Substrat wird daher innerhalb einer Vakuumkammer mindestens ein Target mittels mindestens eines Magnetrons unter Anwesenheit eines Reaktivgases und eines für das Sputtern erforderlichen Arbeitsgases zerstäubt. Sowohl das Arbeitsgas als auch das Reaktivgas werden während des Zerstäubens durch mindestens einen gemeinsamen Einlass oder aber durch separate Einlässe in die Vakuumkammer eingelassen. Verbindungen aus der Reaktion von abgestäubten Targetpartikeln mit dem Reaktivgas werden somit auf dem Substrat abgeschieden. Als Targetmaterialien sind beispielsweise Materialien aus mindestens einem der Elemente Al, Ti, Hf, Ta, Nb, Zr und Zn dotiertes Si geeignet, wobei insbesondere mit dem Targetmaterial Al oder dotiertem Si sehr gute Ergebnisse hinsichtlich einer besonders gut elektrisch isolierenden Schicht erzielt wurden. Als Reaktivgas sind beispielsweise Sauerstoff und Stickstoff und als Arbeitsgas alle aus dem Stand der Technik für das Magnetronsputtern bekannten Arbeitsgase und insbesondere Inertgase geeignet. Das in die Vakuumkammer eingelassene Arbeitsgas kann im einfachsten Fall mit einer konstanten Flussmenge in die Vakuumkammer eingelassen werden. Alternativ ist es auch möglich die Flussmenge des Arbeitsgases mittels eines Regelkreises derart einzustellen, dass der Istwert einer den Sputterprozess charakterisierenden Größe erfasst, mit einem Sollwert dieser Größe verglichen und in Abhängigkeit vom Vergleichsergebnis die Arbeitsgasflussmenge derart geregelt wird, dass der Istwert auf den Sollwert geführt wird. So wird die Flussmenge eines Arbeitsgases bei einer Ausführungsform beispielsweise derart geregelt, dass der Gasdruck innerhalb der Vakuumkammer konstant auf einem Gasdrucksollwert gehalten wird, um gleichbleibende Sputterbedingungen innerhalb der Vakuumkammer zu schaffen.

Erfindungsgemäß wird während des Magnetronsputterns auch noch ein Si-haltiger Precursor in die Vakuumkammer eingelassen. Unter Einfluss des Magnetronplasmas in der Vakuumkammer wird der Precursor aufgespalten, werden die dabei entstehenden Precursorbestandteile aktiviert und zur chemischen Reaktion mit dem Reaktivgas angeregt. Auf diese Weise sind auch Reaktionsprodukte aus einer chemischen Dampfabscheidung am Schichtaufbau beteiligt.

Für das Abscheiden dielektrischer Schichten nach dem erfindungsgemäßen Verfahren ist es wesentlich, dass sowohl Produkte aus der Reaktion abgestäubter Targetpartikel mit dem Reaktivgas als auch Produkte aus der chemischen Reaktion von Precursorbestandteilen mit dem Reaktivgas mit einem Anteil von jeweils mindestens 20 % am Schichtaufbau beteiligt sind. Bei dieser Zusammensetzung hat sich gezeigt, dass die auf diese Weise abgeschiedenen dielektrischen Schichten gute Eigenschaften hinsichtlich der elektrischen Isolation als auch eine Elastizität aufweisen, was das Verwenden dieser Schichten als elektrisch isolierende Schichten auf flexiblen Substraten wie beispielsweise auf Kunststofffolien ermöglicht.

Es ist bekannt, dass das Zuführen von Reaktivgasen und insbesondere von Precursoren in eine Vakuumkammer, in der ein Magnetron betrieben wird, zum Aufwachsen von Schichten auf der Targetoberfläche des Magnetrons führt, die von der Reaktion der Targetoberfläche mit dem Reaktivgas und mit Bestandteilen des Precursors herrühren. Da für das erfindungsgemäße Verfahren ein Sputterabtrag vom Magnetrontarget zwingend erforderlich ist, müssen die Zuflussmengen vom Reaktivgas und insbesondere die Zuflussmenge vom Precursor in die Vakuumkammer derart eingestellt werden, dass das Abtragen dieser Schichten mittels Sputtern zumindest im Bereich des Erosionsgrabens auf der Targetoberfläche schneller erfolgt als das Aufwachsen der Schichten auf der Targetoberfläche.

Beim erfindungsgemäßen Verfahren wird zunächst einmal die Zuflussmenge des Reaktivgases derart eingestellt oder aber auch nach bekannten Verfahrensschritten derart geregelt, dass ein Arbeitspunkt des Magnetron-Sputterns im Übergangsgebiet vom metallischen Mode zum reaktiven Mode aufrechterhalten wird. Als zweites muss noch die Zuflussmenge des Precursors eingestellt werden.

Die Grenzmenge des Zuflusses eines Precursors, bis zu der die auf der Targetoberfläche aufwachsenden Schichten im Bereich des Erosionsgrabens noch schneller durch Sputtern abgetragen werden können als diese wieder Aufwachsen, hängt von verschiedenen Parametern einer jeweiligen Anlagenkonfiguration, wie beispielsweise vom Targetmaterial, der Oberflächengröße des Targets, der Sputterleistung und der Precursorart ab, kann aber für jede Konfiguration relativ einfach in Testversuchen ermittelt werden. Beim Durchführen des erfindungsgemäßen Verfahrens wird bei einer Ausführungsform der Zufluss des Precursors fest auf eine Flussmenge eingestellt, die sich unterhalb der bei Testversuchen ermittelten Grenzmenge befindet. Alternativ kann die Zuflussmenge des Precursors während des Abscheidens einer elektrisch isolierenden Schicht auch innerhalb des Bereiches von größer Null bis hin zu dieser Grenzmenge variiert werden, um beispielsweise einen Gradienten bezüglich des Anteils der am Schichtaufbau beteiligten Partikel einzustellen, die vom Sputterprozess herrühren. Je höher die Zuflussmenge des Precursors gewählt wird, umso geringer ist der Anteil der Partikel, die vom Target abgestäubt und am Schichtaufbau beteiligt werden und umgekehrt. Ein Schichtgradient kann alternativ, aber auch über das Verändern der Sputterleistung eingestellt werden. Je höher die Sputterleistung, umso höher ist auch der Anteil der durch Sputtern bereitgestellten Teilchen am Schichtaufbau.

Wie bereits erwähnt, wird bei.einem erfindungsgemäßen Verfahren ein Si-haltiger Percursor während des Sputterprozesses in die Vakuumkammer eingelassen. Als Precursor können alle gasförmigen Si-haltigen Precursoren verwendet werden. Besonders geeignet sind beispielsweise HMDSO, TEOS, SiH₄, HMDS und HMDSN, weil sich aufgrund derer hoher Dampfdrücke die technische Umsetzung der Gaszufuhr relativ einfach umsetzen lässt.

Besonders gute und bisher aus dem Stand der Technik nicht bekannte Werte hinsichtlich der elektrischen Isolationsfestigkeit konnten erzielt werden, wenn das erfindungsgemäße Verfahren zum Abscheiden eines dielektrischen Mehrschichtsystems verwendet wird. Hierbei werden die erfindungsgemäß abgeschiedenen Schichten im Wechsel mit dielektrischen Magnetron-Sputterschichten abgeschieden. Ein solches erfindungsgemäßes Mehrschichtsystem umfasst mindestens eine dielektrische Schicht, die mittels Magnetron-Sputtern abgeschieden wird und eine Schicht, die mittels des erfindungsgemäßen Verfahrens abgeschieden wird. Es können aber auch beliebig viele Schichten der zwei beschriebenen Schichtarten im Wechsel abgeschieden werden. Vorteilhaft bzw. hinreichend für eine sehr gute elektrische Isolation eines solchen dielektrischen Mehrschichtsystems ist es, wenn jeweils 2 bis 20 Einzelschichten der zwei Schichtarten mit einer Schichtdicke von 0,1 µm bis 3 µm im Wechsel abgeschieden werden. Aufgrund des Wechsels in der Schichtfolge wird ein erfindungsgemäßes Mehrschichtsystem nachfolgend auch Wechselschichtsystem genannt. Für ein erfindungsgemäßes Mehrschichtsystem ist es unwesentlich, mit welcher der beiden Schichtarten der Abscheideprozess begonnen wird.

Als dielektrische Einzelschichten, die mittels Magnetron-Sputtern erzeugt werden, können bei einem erfindungsgemäßen Mehrschichtsystem alle aus dem Stand der Technik bekannten dielektrischen Magnetron-Sputterschichten verwendet werden. Besonders geeignet sind Magnetron-Sputterschichten aus SiO₂, Al₂O₃, Si₃N₄ oder Ta₂O₅.

Das Ausbilden eines solchen dielektrischen Mehrschichtsystems ist gut mit dem erfindungsgemäßen Verfahren zum Abscheiden dielektrischer Schichten kombinierbar und beispielsweise auch mit einfachen technischen Mitteln innerhalb einer Vakuumkammer durchführbar. Hierfür braucht lediglich während des Abscheidens einer dielektrischen Magnetron-Sputterschicht der Zufluss des Precursors in die Vakuumkammer gestoppt zu werden, so dass nur noch vom Magnetron abgestäubte Teilchen nach Reaktion mit dem in die Vakuumkammer eingelassenen Reaktivgas auf einem Substrat abgeschieden werden. Für das Abscheiden einer weiteren dielektrischen Schicht nach dem erfindungsgemäßen Verfahren wird dann wieder der Precursor in die Vakuumkammer eingelassen und die Zuflussmengen von Precursor, Reaktivgas und Arbeitsgas derart eingestellt bzw. geregelt, wie es oben zum erfindungsgemäßen Verfahren beschrieben ist. Für eine weitere dielektrische Magnetron-Sputterschicht wird dann abermals der Precursorzufluss in die Vakuumkammer unterbrochen und eine weitere reine Magnetron-Sputterschicht abgeschieden usw.

Alternativ kann das wechselweise Abscheiden von dielektrischen Magnetron-Sputterschichten und erfindungsgemäß abgeschiedenen dielektrischen Schichten auch in separaten Vakuumkammern oder Vakuumkammerbereichen erfolgen.

Sowohl das erfindungsgemäße Verfahren zum Abscheiden einer dielektrischen Schicht als auch die Verwendung dieses Verfahrens zum Abscheiden eines Mehrschichtsystems können an ruhenden und auch an bewegten Substraten durchgeführt werden.

### Ausführungsbeispiel

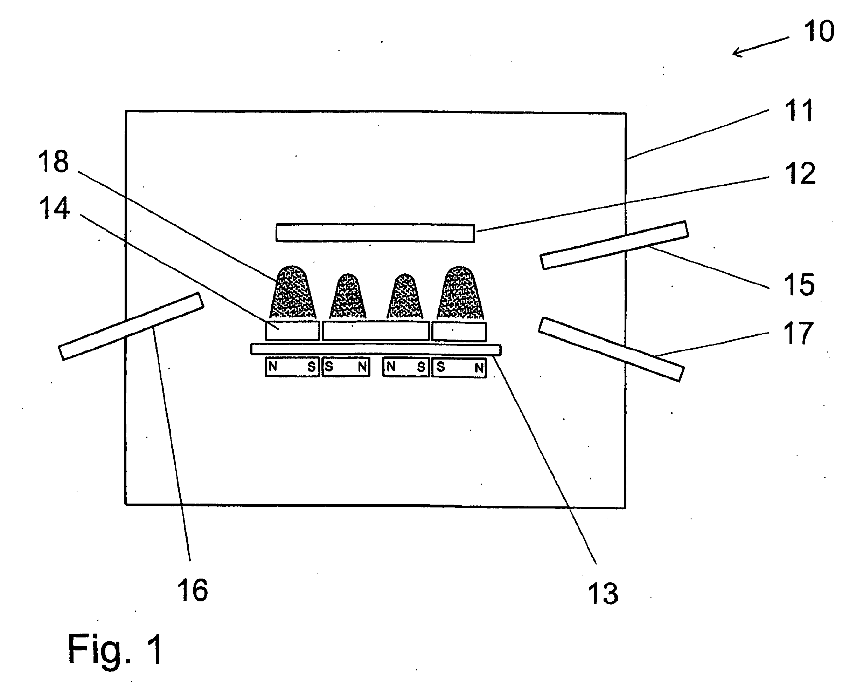

Die Erfindung wird nachfolgend anhand eines Ausführungsbeispiels näher erläutert. Fig. 1 zeigt eine schematische Darstellung einer Vorrichtung 10, mittels der das erfindungsgemäße Verfahren durchführbar ist.

Bei einer Art von Sensoren wird auf einem elastischen und elektrisch leitfähigen Substrat eine sensorisch wirksame Schicht aufgetragen. Für die Funktion eines solchen Sensors ist es erforderlich, eine elektrische Isolationsschicht zwischen dem Grundkörper und der sensorisch wirksamen Schicht abzuscheiden. Mittels der Vorrichtung 10 soll eine solche dielektrische Schicht mit einem stationären Beschichtungsprozess innerhalb einer Vakuumkammer 11 nacheinander auf einer Gruppe von elastischen und elektrisch leitfähigen Substraten 12 abgeschieden werden.

Hierfür werden bei einem ersten Beispiel A zunächst mittels eines Doppelring-Magnetrons 13, welches mit Targets 14 (ein ringförmiges äußeres und ein scheibenförmiges inneres Target) aus Silizium bestückt ist, Siliziumpartikel von der Targetoberfläche abgestäubt. Während des Sputterns, welches mit einer Leistung von 2000 W am äußeren und 500 W am inneren Target betrieben wird, werden das Sputterarbeitsgas Argon durch einen Einlass 15 und das Reaktivgas Sauerstoff durch einen Einlass 16 in die Vakuumkammer 11 eingelassen. Die von den Targets 14 abgestäubten Siliziumpartikel werden somit in einem reaktiven Prozess mit dem in die Vakuumkammer 11 eingelassenen Sauerstoff als Siliziumoxidpartikel auf dem Substrat 12 abgeschieden. Mittels eines ersten Regelkreises, in welchem Istwerte für den Druck in der Vakuumkammer 11 erfasst und mit einem Drucksollwert verglichen werden, wird die Flussmenge des Sputtergases Argon derart geregelt, dass der Druck in der Vakuumkammer 11 entsprechend des Drucksollwertes von 0,3 Pa aufrechterhalten bleibt.

Mittels eines aus dem Stand der Technik bekannten zweiten Regelkreises wird die Sauerstoffzuflussmenge in die Vakuumkammer 11 derart geregelt, dass ein Arbeitspunkt des Magnetron-Sputterns im Übergangsbereich zwischen dem metallischen Mode und dem reaktiven Mode aufrechterhalten bleibt, bei dem zumindest die Erosionsgräben der Targets 14 von Siliziumoxidschichten freigehalten werden.

Durch einen Einlass 17 wird schließlich auch noch der Precursor HMDSO in die Vakuumkammer 11 eingelassen. Innerhalb der Vakuumkammer 11 ist der Precursor dem Einfluss des Magnetronplasmas 18 ausgesetzt, wodurch der Precursor aufgespalten und aktiviert wird, wodurch die aufgespaltenen Bestandteile zur chemischen Schichtabscheidung angeregt werden. Auf den Substraten 12 wird somit eine dielektrische Schicht abgeschieden, die einerseits aus den vom reaktiven Magnetron-Sputtern herrührenden Siliziumoxidpartikeln und andererseits aus chemischen Reaktionsprodukten aus der Reaktion von Precursorbestandteilen mit dem Reaktivgas besteht.

Da sich die Precursorbestandteile nicht nur auf dem Substrat 12 sondern auch auf der Oberfläche der Targets 14 niederschlagen und somit das Magnetron-Sputtern beeinträchtigen, wurde vor dem Abscheiden der dielektrischen Schicht auf dem Substrat 12 in Testversuchen bei der gegebenen Anlagenkonfiguration die Grenzzuflussmenge für den Precursor ermittelt, bis zu der das Aufwachsen einer Schicht auf der Targetoberfläche durch Precursorbestandteile nur so langsam erfolgt, dass noch der Sputterabtrag von der Targetoberfläche dominiert. Die Tests zeigen, dass dies dann der Fall ist, wenn bei einer Schichtabscheidung auf einem Substrat noch mindestens 40 % des Schichtanteils vom Magnetron-sputtern herrühren. Bei der konkreten Anlagenkonfiguration wurde für diese Grenzzuflussmenge ein Wert von 6 sccm ermittelt. Während des Abscheidens der dielektrischen Schicht wurde die Zuflussmenge des Precursors auf 5 sccm eingestellt. Daraus resultiert bei der Schichtabscheidung ein Schichtanteil von 46 % herrührend vom Magnetron-Sputterprozess.

Bei einem zweiten Beispiel B soll mit der in Fig. 1 schematisch dargestellten Anlagenkonfiguration ein dielektrisches Wechselschichtsystem nacheinander auf einer weiteren Gruppe von Substraten 12 abgeschieden werden. Hierbei wird zunächst eine 1 µm dicke dielektrische Schicht erfindungsgemäß abgeschieden, mit den Parametern und Verfahrensschritten, wie sie oben zum Ausführungsbeispiel A beschrieben sind. Danach wird die Zufuhr des Precursors HMDSO durch den Einlass 17 in die Vakuumkammer 11 gestoppt und in einem bekannten reaktiven Magnetron-Sputterverfahren eine 1 µm dicke dielektrische Siliziumdioxidschicht abgeschieden. Anschließend wird abermals der Precursor HMDSO durch den Einlass 17 in die Vakuumkammer eingelassen und mit den Parametern und Verfahrensschritten, wie sie zum Ausführungsbeispiel A beschrieben sind, eine weitere 1 µm dicke erfindungsgemäße dielektrische Schicht abgeschieden. Auf diese Weise werden insgesamt jeweils drei dielektrische Schichten mit dem erfindungsgemäßen Verfahren und drei dielektrische Siliziumdioxid-Sputterschichten im Wechsel und von jeweils 1 µm Dicke abgeschieden, so dass ein dielektrisches Wechselschichtsystem von insgesamt 6 µm Dicke entsteht.

Zu Vergleichszwecken wurde in einem dritten Beispiel C eine dritte Gruppe von Substraten 12 gleicher Bauart wie aus den Beispielen A und B mit einer 6 µm dicken Vergleichsschicht aus Siliziumdioxid mit einem reaktiven Magnetron-Sputterverfahren beschichtet.

Die in den Beispielen A, B und C abgeschiedenen Schichten bzw. Schichtsysteme wurden einem Test hinsichtlich der elektrischen Isolationsfestigkeit unterzogen. Dabei wurde jeweils mit drei Prüfspannungen 250 V, 500 V und 800 V getestet. In Tab. 1 ist die prozentuale Ausbeute bei den drei Beispielen hinsichtlich der Isolationsfestigkeit festgehalten.

**Tab. 1**

| Schicht | Ausbeute [%] | | |
|---|---|---|---|
| | 250V | 500V | 800V |
| Beispiel A | 100 | 47 | 19 |
| Beispiel B | 100 | 100 | 70 |
| Beispiel C | 100 | 46 | 23 |

Der Tab. 1 ist zu entnehmen, dass die mit dem reinen erfindungsgemäßen Verfahren abgeschiedenen dielektrischen Schichten aus dem Beispiel A eine ähnlich hohe Ausbeute hinsichtlich der elektrischen Isolationsfestigkeit aufweisen, wie die dielektrischen Magnetron-Sputterschichten aus dem Beispiel C, von denen bekannt ist, dass diese gute elektrische Isolationseigenschaften aufweisen. Noch bessere Ergebnisse hinsichtlich der elektrischen Isolationsfestigkeit konnten mit den Wechselschichtsystemen aus Beispiel B erzielt werden. Die Wechselschichtsysteme aus dem Beispiel B und die mit dem reinen erfindungsgemäßen Verfahren abgeschiedenen Schichten aus Beispiel A weisen jedoch gegenüber den reinen Magnetron-Sputterschichten aus Beispiel C den Vorteil auf, dass diese eine größere Elastizität aufweisen. Während die Magnetron-Sputterschichten aus Beispiel C bei einer Biegebeanspruchung der Substrate 12 zur Rissbildung neigten, konnte bei den Schichten und Schichtsystemen aus den Beispielen A und B keine Rissbildung beobachtet werden.

Auch wenn die Ausführungsbeispiele ausschließlich anhand eines Doppelringmagnetrons, anhand des Targetmaterials Silizium, anhand des Reaktivgases Sauerstoff und anhand des Precursors HMDSO beschrieben wurde, sei an dieser Stelle angemerkt, dass beim Durchführen des erfindungsgemäßen Verfahrens und zum Abscheiden eines erfindungsgemäßen Wechselschichtsystems alle in der allgemeinen Beschreibung benannten Targetmaterialien und Reaktivgase, alle gasförmigen Si-haltigen Precursoren und alle aus dem Stand der Technik bekannten Sputter-Magnetrons verwendet werden können.

## Patentansprüche

1. Verfahren zum Abscheiden einer dielektrischen Schicht auf einem Substrat 12 innerhalb einer Vakuumkammer 11, wobei mindestens ein Target 14, bestehend aus mindestens einem der Materialien Al, Ti, Hf, Ta, Nb, Zr, Zn dotiertes Si, mittels mindestens eines Magnetrons 13 bei Zufuhr eines Arbeitsgases und eines Reaktivgases in die Vakuumkammer 11 zerstäubt wird, **dadurch gekennzeichnet, dass** während des Zerstäubens ein Si-haltiger Precursor in die Vakuumkammer 11 eingelassen wird, wobei die Flussmengen des Reaktivgases und des Precursors in die Vakuumkammer 11 derart eingestellt werden, dass sowohl Produkte aus der Reaktion abgestäubter Targetpartikel mit dem Reaktivgas als auch Produkte aus der Reaktion von Precursorbestandteilen mit dem Reaktivgas zu jeweils mindestens 20 % am Schichtaufbau beteiligt sind.

2. Verfahren nach Anspruch 1, **dadurch gekennzeichnet, dass** die Flussmengen des Reaktivgases und des Precursors derart eingestelh werden, dass die Produkte aus der Reaktion abgestäubter Targetpartikel mit dem Reaktivgas zu 45 % bis 55 % am Schichtaufbau beteiligt sind.

3. Verfahren nach Anspruch 1 oder 2, **dadurch gekennzeichnet, dass** Sauerstoff oder Stickstoff als Reaktivgas verwendet werden.

4. Verfahren nach einem der vorhergehenden Ansprüche, **dadurch gekennzeichnet, dass** HMDSO, TEOS, HMDSN, HMDS oder SiH₄ als Precursor verwendet werden.

5. Verfahren nach einem der vorhergehenden Ansprüche, **dadurch gekennzeichnet, dass** der Istwert einer den Magnetron-Sputterprozess charakterisierenden physikalischen Größe erfasst, mit einem Sollwert dieser Größe verglichen und in Abhängigkeit vom Vergleichsergebnis der Arbeitsgaszufluss in die Vakuumkammer derart geregelt wird, dass der Istwert auf den Sollwert geführt wird.

6. Verfahren nach einem der vorhergehenden Ansprüche, **dadurch gekennzeichnet, dass** die Zuflussmenge des Reaktivgases derart geregelt wird, dass ein Arbeitspunkt im Übergangsbereich zwischen dem metallischen Mode und dem reaktiven Mode aufrechterhalten bleibt.

7. Verfahren nach einem der vorhergehenden Ansprüche, **dadurch gekennzeichnet, dass** in einem Testversuch vor dem Abscheiden der dielektrischen Schicht eine Grenzmenge für den Zufluss des Precursors in die Vakuumkammer 11 ermittelt wird, bis zu der das Aufwachsen von Schichten auf der Targetoberfläche langsamer erfolgt als das Absputtern dieser aufwachsenden Schichten.

8. Verfahren nach Anspruch 7, **dadurch gekennzeichnet, dass** die Zuflussmenge des Precursors in die Vakuumkammer 11 beim Abscheiden der dielektrischen Schicht in einem Bereich zwischen Null und der Grenzmenge eingestellt wird.

9. Verwendung eines Verfahrens nach einem der vorhergehenden Ansprüche zum Abscheiden eines dielektrischen Mehrschichtsystems, **dadurch gekennzeichnet, dass** mindestens eine dielektrische erste Schicht mittels eines Verfahrens nach einem der vorhergehenden Ansprüche und mindestens eine dielektrische zweite Schicht mittels eines Magnetron-Sputterverfahrens in beliebiger Reihenfolge abgeschieden werden.

10. Verwendung nach Anspruch 9, **dadurch gekennzeichnet, dass** mehrere erste und zweite Schichten Wechselweise abgeschieden werden.

## Claims

1. Method for depositing a dielectric layer on a substrate 12 within a vacuum chamber 11, wherein at least one target 14, consisting of at least one of the materials Al, Ti, Hf, Ta, Nb, Zr, Zn-doped Si, is sputtered by means of at least one magnetron 13 when a working gas and a reactive gas are fed into the vacuum chamber 11, **characterized in that**, during the sputtering, an Si-containing precursor is admitted into the vacuum chamber 11, wherein the flow rates of the reactive gas and of the precursor into the vacuum chamber 11 are set in such a manner that both products from the reaction of evaporated target particles with the reactive gas and products from the reaction of precursor constituents with the reactive gas are involved to an extent in each case of at least 20% in the layer structure.

2. Method according to Claim 1, **characterized in that** the flow rates of the reactive gas and of the precursor are set in such a manner that the products from the reaction of evaporated target particles with the reactive gas are involved to an extent of 45% to 55% in the layer structure.

3. Method according to Claim 1 or 2, **characterized in that** oxygen or nitrogen are used as the reactive gas.

4. Method according to one of the preceding claims, **characterized in that** HMDSO, TEOS, HMDSN, HMDS or SiH₄ are used as the precursor.

5. Method according to one of the preceding claims, **characterized in that** the actual value of a physical variable characterizing the magnetron sputtering process is detected, compared with a desired value of this variable and regulated depending on the comparative result of the working gas influx into the vacuum chamber in such a manner that the actual value is led towards the desired value.

6. Method according to one of the preceding claims, **characterized in that** the influx rate of the reactive gas is regulated in such a manner that an operating point is maintained in the transition region between the metallic mode and the reactive mode.

7. Method according to one of the preceding claims, **characterized in that**, in a test attempt before the deposition of the dielectric layer, a limit rate for the influx of the precursor into the vacuum chamber 11 up to which the growth of layers on the target surface takes place more slowly than the sputtering of said growing layers is determined.

8. Method according to Claim 7, **characterized in that** the influx rate of the precursor into the vacuum chamber 11 is set during deposition of the dielectric layer in a range between zero and the limit rate.

9. Use of a method according to one of the preceding claims for depositing a dielectric multilayer system, **characterized in that** at least one dielectric first layer is deposited by means of a method according to one of the preceding claims and at least one dielectric second layer is deposited by means of a magnetron sputtering method in any desired order.

10. Use according to Claim 9, **characterized in that** a plurality of first and second layers are deposited alternately.

## Revendications

1. Procédé de dépôt d'une couche diélectrique sur un substrat (12) à l'intérieur d'une chambre (11) en dépression, dans lequel au moins une cible (14) constituée de Si dopé à l'aide d'au moins l'un des matériaux Al, Ti, Hf, Ta, Nb, Zr, Zn est pulvérisée au moyen d'au moins un magnétron (13) tout en apportant un gaz de travail et un gaz réactif dans la chambre (11) en dépression,
**caractérisé en ce que**
pendant la pulvérisation, un précurseur contenant du Si est apporté dans la chambre (11) en dépression,
**en ce que** les débits d'écoulement du gaz réactif et du précurseur entrant dans la chambre (11) en dépression sont ajustés de telle sorte que tant les produits de la réaction des particules de cible pulvérisées avec le gaz réactif que les produits de la réaction des composants précurseurs avec le gaz réactif contribuent chacun à au moins 20 % à la formation de la couche.

2. Procédé selon la revendication 1, **caractérisé en ce que** les débits du gaz réactif et du précurseur sont ajustés de telle sorte que les produits de la réaction des particules de cible pulvérisées avec le gaz réactif contribuent à raison de 45 % à 55 % à la formation de la couche.

3. Procédé selon les revendications 1 ou 2, **caractérisé en ce qu'**il utilise l'oxygène ou l'azote comme gaz réactif.

4. Procédé selon l'une des revendications précédentes, **caractérisé en ce qu'**il utilise comme précurseur le HMDSO, le TEOS, le HMDSM, le HMDS ou SiH₄.

5. Procédé selon l'une des revendications précédentes, **caractérisé en ce que** la valeur effective d'une grandeur physique qui caractérise l'opération de pulvérisation par magnétron est saisie et est comparée à une valeur de consigne de cette grandeur et **en ce que** l'apport de gaz de travail dans la chambre en dépression est régulé en fonction du résultat de la comparaison de manière à amener la valeur effective à la valeur de consigne.

6. Procédé selon l'une des revendications précédentes, **caractérisé en ce que** le débit d'amenée de gaz réactif est régulé de manière à maintenir un point de travail dans la zone de transition entre le mode métallique et le mode réactif.

7. Procédé selon l'une des revendications précédentes, **caractérisé en ce que** lors d'un essai de test réalisé avant le dépôt de la couche diélectrique, une quantité limite d'amenée de précurseur dans la chambre (11) en dépression est déterminée jusqu'à ce que la croissance de couche sur la surface de la cible s'effectue plus lentement que la pulvérisation de ces couches en croissance.

8. Procédé selon la revendication 7, **caractérisé en ce que** lors du dépôt de la couche diélectrique, le débit d'amenée de précurseur dans la chambre (11) en dépression est ajusté dans une plage comprise entre zéro et le débit limite.

9. Utilisation d'un procédé selon l'une des revendications précédentes pour déposer un système constitué de plusieurs couches diélectriques, **caractérisée en ce que** dans une succession quelconque, au moins une première couche diélectrique est déposée au moyen du procédé selon l'une des revendications précédentes et au moins une deuxième couche diélectrique est déposée au moyen d'un procédé de pulvérisation par magnétron.

10. Utilisation selon la revendication 9, **caractérisée en ce que** plusieurs premières couches et plusieurs deuxièmes couches sont déposées en alternance.
